# EUROPEAN PATENT APPLICATION

(11) **EP 4 749 254 A1**
(43) Date of publication of application: **27.05.2026**
(21) Application number: 25214855.6
(22) Date of filing: 11.11.2025
(51) Int. Cl.: G01L 9/00, B81B 3/00, B81C 1/00

(54) **IMPROVED CAPACITIVE MICROELECTROMECHANICAL PRESSURE TRANSDUCER AND RELATED MANUFACTURING PROCESS**

(30) Priority: 25.11.2024 IT 202400026475
(71) Applicant: STMicroelectronics International N.V., 1228 Plan-les-Ouates, Geneva (CH)
(72) Inventor: CAPRA, Federica, 20864 AGRATE BRIANZA (MB) (IT); NICOLI, Silvia, 20864 AGRATE BRIANZA (MB) (IT); D'ERCOLI, Filippo, 20864 AGRATE BRIANZA (MB) (IT)
(74) Representative: Studio Torta S.p.A.

(57) **Abstract**

MEMS pressure transducer (100) including: a semiconductor body (2); a fixed electrode region (12); and a membrane (155), which is suspended above the fixed electrode region (12) so as to delimit a cavity (39), the membrane (155) being deformable as a function of pressure. The membrane (155) includes: a lower conductive region (36) of polysilicon, which delimits the cavity (39) at the top and is traversed by one or more holes (38) which face the cavity (39), the lower conductive region (36) being impermeable to gases, except for the holes (38); an intermediate structure (146;246) of polysilicon permeable to gases, which closes the holes (38); and an upper conductive region (156) of polysilicon or amorphous silicon, which extends on the intermediate structure (146;246) and the lower conductive region (36) and is impermeable to gases. The membrane (155) is laterally delimited by a lateral surface (Sₗₐₜ), which is formed by the lower conductive region (36) and the upper conductive region (156); the intermediate structure (146;246) does not face the lateral surface (Sₗₐₜ) of the membrane (155).

## Description

### Technical Field

The present invention relates to an improved capacitive microelectromechanical (MEMS) pressure transducer and to the related manufacturing process.

### Background

As is known, numerous capacitive-type MEMS pressure transducers are available nowadays, which envisage forming a capacitor including an electrode formed by a membrane, which delimits a cavity and deforms at least in part as a function of pressure; in this manner, pressure variations are transduced into capacitance variations, which may be sensed electronically.

For example, the European patent application no. 24177856.2, which was filed on May 24, 2024 in the name of the Applicant and belongs to the same patent family as the application US 18/665062 filed on May 15, 2024, describes a MEMS transducer 1, which is shown in Figure 1 together with an orthogonal reference system XYZ.

The MEMS transducer 1 comprises a semiconductor body 2, which is delimited at the top by a front surface S₂, parallel to the XY plane. A buried cavity 3 extends within the semiconductor body 2, at a distance from the front surface S₂. Furthermore, a lower portion of a trench 11 extends through part of the semiconductor body 2, starting from the front surface S₂, so as to communicate at the bottom with the buried cavity 3 and laterally delimit a suspended portion 9' of the semiconductor body 2, which delimits the buried cavity 3 at the top. The suspended portion 9' of the semiconductor body 2 extends in a cantilever manner, above the buried cavity 3, starting from a fixed portion 9" of the semiconductor body 2.

The MEMS transducer 1 also comprises a lower dielectric region 4, which extends above the front surface S₂, in direct contact with the semiconductor body 2, and is formed for example by thermal oxide. Part of the lower dielectric region 4 covers the fixed portion 9" of the semiconductor body 2. Furthermore, part of the lower dielectric region 4 extends on the suspended portion 9' of the semiconductor body 2.

The MEMS transducer 1 also comprises a stopping region 6, which extends above the lower dielectric region 4 and is formed by aluminum oxide (Al₂O₃). Part of the stopping region 6 partially covers the part of the lower dielectric region 4 that covers the fixed portion 9" of the semiconductor body 2. Furthermore, part of the stopping region 6 extends on the part of the lower dielectric region 4 that overlies the suspended portion 9' of the semiconductor body 2. The stopping region 6 does not entirely cover the lower dielectric region 4, but leaves a part of the lower dielectric region 4 exposed.

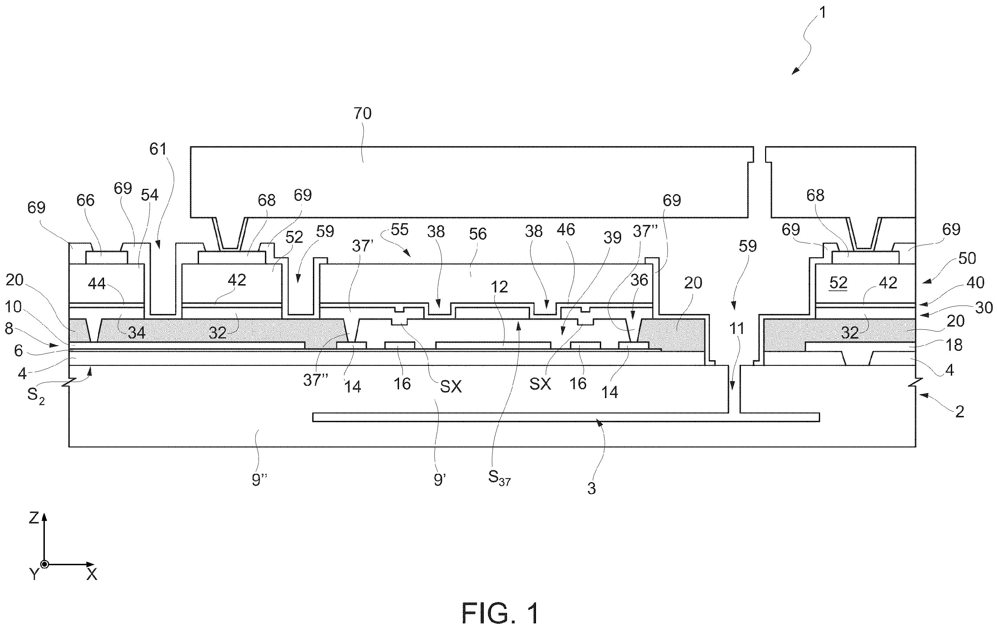

The MEMS transducer 1 further comprises a lower conductive structure 8 of polysilicon, which comprises a routing region 10, which extends on a portion of the stopping region 6 that overlies, at a distance, the fixed portion 9" of the semiconductor body 2. The lower conductive structure 8 further comprises a lower electrode region 12, a lower anchoring region 14 and a covering region 16, which are therefore formed by polysilicon, extend on the part of the stopping region 6 that overlies, at a distance, the suspended portion 9' of the semiconductor body 2 and are coplanar with each other and with the routing region 10. Furthermore, the lower electrode region 12, the lower anchoring region 14 and the covering region 16 are laterally separated from each other. Furthermore, the lower conductive structure 8 comprises a pair of connection regions (not visible in Figure 1), which connect the lower anchoring region 14 and the covering region 16.

The lower conductive structure 8 also comprises a ground contact region 18, which extends on the part of the lower dielectric region 4 left exposed by the stopping region 6 and is laterally offset with respect to the buried cavity 3; furthermore, the ground contact region 18 is separated from the routing region 10, the lower electrode region 12, the lower anchoring region 14 and the covering region 16 and extends in part through the lower dielectric region 4, so as to contact, at the bottom, the fixed portion 9" of the semiconductor body 2.

The lower electrode region 12, the lower anchoring region 14 and the covering region 16 overlie, at a distance, the buried cavity 3. The lower electrode region 12 is partially surrounded by the covering region 16. Furthermore, although not shown here, the lower anchoring region 14 has an elongated shape, approximately a 'C' shape (in top view) and laterally surrounds the covering region 16.

Although not shown, the lower conductive structure 8 further comprises a contact region (not shown), which is coplanar with the lower electrode region 12, the lower anchoring region 14, the covering region 16 and the connection regions (not shown) and is interposed between the lower electrode region 12 and the routing region 10, so as to electrically connect them. Furthermore, the lower anchoring region 14, the covering region 16, and the connection regions form a single region that laterally surrounds, at a distance, the lower electrode region 12.

The MEMS transducer 1 further comprises an upper dielectric region 20, which is formed by TEOS oxide and extends above the routing region 10 and the ground contact region 18, as well as above an external portion of the lower anchoring region 14. The upper dielectric region 20 also extends on the part of the lower dielectric region 4 left exposed by the stopping region 6 and on the portions of the stopping region 6 which extend in the space that separates the external portion of the lower anchoring region 14 from the routing region 10. An upper portion of the trench 11 extends through the part of the upper dielectric region 20 which extends on the part of the lower dielectric region 4 left exposed by the stopping region 6 and laterally offset with respect to the ground contact region 18.

The MEMS transducer 1 further comprises a first, a second and a third upper conductive structure 30, 40, 50, which are formed by polysilicon and have approximately a same shape, in top view (not shown).

The first upper conductive structure 30 has a thickness comprised for example between 200nm and 500nm, is formed by polysilicon impermeable to gases and comprises a respective annular region 32, which in top view has an annular shape and extends above portions of the upper dielectric region 20, in direct contact. The annular region 32 of the first upper conductive structure 30 extends above portions of the upper dielectric region 20 that overlie the routing region 10 and above portions of the upper dielectric region 20 that overlie the ground contact region 18. Although not shown, part of the annular region 32 traverses the upper dielectric region 20, so as to contact the ground contact region 18. Furthermore, although not shown, in top view the annular region 32 surrounds the trench 11 and also overlies, at a distance, the fixed portion 9" of the semiconductor body 2.

The first upper conductive structure 30 further comprises a respective peripheral region 34, which extends above a portion of the upper dielectric region 20 that overlies the routing region 10, outside the annular region 32; furthermore, the peripheral region 34 also extends through the upper dielectric region 20, so as to contact the underlying routing region 10.

The first upper conductive structure 30 further comprises an internal region 36, hereinafter referred to as the first internal region 36. The first internal region 36 comprises a suspended portion 37' and an anchoring portion 37", which form a single monolithic region of polysilicon.

Although not shown, the anchoring portion 37" has an elongated shape, approximately a 'C' shape, in top view; furthermore, the anchoring portion 37" is arranged above the lower anchoring region 14, with which it is in direct contact, and laterally delimits a sensing cavity 39. The anchoring portion 37" has a width (in the XY plane, along the perimeter of the respective elongated shape) smaller than the width of the lower anchoring region 14 and is arranged with respect to the latter so as to leave exposed an internal portion of the lower anchoring region 14, which faces the sensing cavity 39, and also to be laterally offset with respect to the aforementioned external portion of the lower anchoring region 14, which as mentioned is overlaid by the upper dielectric region 20.

The suspended portion 37' extends above the anchoring portion 37", so as to delimit the sensing cavity 39 at the top, which is delimited at the bottom by the internal portion of the lower anchoring region 14, the lower electrode region 12, the covering region 16 and by portions of the stopping region 6 arranged below the suspended portion 37' and left exposed by the lower electrode region 12, the lower anchoring region 14 and the covering region 16.

The suspended portion 37' is traversed by a plurality of holes 38 (two visible in Figure 1) of the through type, which face at the bottom the sensing cavity 39. Furthermore, the suspended portion 37' extends laterally so as to protrude in part outside the anchoring portion 37". The part of suspended portion 37' that protrudes externally with respect to the underlying anchoring portion 37" overlies a corresponding portion of the upper dielectric region 20, in direct contact.

The suspended portion 37' is delimited at the bottom by a flat surface S₃; furthermore, the suspended portion 37' forms protection structures SX (optional), which depart from the flat surface S₃₇ in the direction of the lower conductive structure 8.

Although not visible in Figure 1, the anchoring portion 37" laterally delimits a lateral opening of the sensing cavity 39, such lateral opening being delimited at the top by the suspended portion 37' and facing a corresponding portion of the upper dielectric region 20, which laterally closes this lateral opening, such that the sensing cavity 39 is hermetically closed, with an internal pressure that may for example be comprised between 1µbar and 1bar.

The second upper conductive structure 40 has a thickness comprised for example between 100nm and 300nm, is formed by polysilicon permeable to gases and comprises a respective annular region 42, which overlies the annular region 32 of the first upper conductive structure 30, in direct contact. In top view, the annular region 42 has approximately the same shape as the annular region 32. The second upper conductive structure 40 also comprises a respective peripheral portion 44, which extends above the peripheral portion 34 of the first upper conductive structure 30; in top view (not shown), the peripheral portion 44 has approximately the same shape as the peripheral portion 34. The second upper conductive structure 40 also comprises a second internal region 46, which is layered and extends on the first internal region 36 and within the holes 38, for example in a conformal manner, therefore without completely filling the holes 38, but coating the relative lateral walls and the respective bottoms. The portions of the second internal region 46 which extend on the bottom of the holes 38 therefore face the sensing cavity 39.

The third upper conductive structure 50 is formed by polysilicon impermeable to gases and comprises a respective annular region 52, which overlies the annular region 42 of the second upper conductive structure 40, in direct contact; in top view (not shown), the annular region 52 has approximately the same shape as the annular region 42. The third upper conductive structure 50 further comprises a respective peripheral portion 54, which extends above the peripheral portion 44 of the second upper conductive structure 40; in top view, the peripheral portion 54 has approximately the same shape as the peripheral portion 44. The third upper conductive structure 50 further comprises a third internal region 56, which extends on the second internal region 46 and comprises portions which extend within the holes 38, so as to fill them. In other words, in each hole 38 a corresponding portion of the third internal region 56 is present, which is coated laterally and at the bottom by a corresponding portion of the second internal region 46.

The first, second and third internal regions 36, 46, 56 have approximately a same shape, in top view. Furthermore, the part of the suspended portion 37' that overlies the sensing cavity 39 and the overlying portions of the second and the third internal regions 46, 56 form a membrane 55 of polysilicon, which has a thickness for example comprised between 1µm and 6µm, functions as the upper electrode of a sensing capacitor of variable-type and faces the underlying lower electrode region 12, which functions as the fixed lower electrode of the sensing capacitor.

In addition, the first, the second and third upper conductive structure 30, 40, 50 are patterned such that the membrane 55 is separated laterally, through an upper trench 59, from the annular regions 32, 42, 52. Furthermore, the peripheral portions 34, 44, 54 are separated from the annular regions 32, 42, 52 by an opening 61, which faces the upper dielectric region 20. A part of the upper trench 59 faces the upper dielectric region 20, while another part of the upper trench 59 faces the underlying upper portion of the trench 11, with which it is in fluidic communication.

The MEMS transducer 1 also comprises a plurality of pads 66 of conductive material (e.g., aluminum, copper or gold). In Figure 1, only one pad 66 is visible, which overlies the peripheral portion 54 of the third upper conductive structure 50, in direct contact, so as to be in electrical contact with the routing region 10, and therefore also with the lower electrode region 12. Although not shown, a further pad is electrically connected to the lower anchoring region 14, so as to be set at the same potential as the membrane 55.

The MEMS transducer 1 also comprises a coupling conductive region 68, which is formed for example by metal material (e.g., copper, aluminum or gold), has an annular shape and extends above the annular region 52 of the third upper conductive structure 50, in direct contact. Although not shown, the coupling conductive region 68 may be electrically connected to the ground contact region 18, so as to be set at the same potential as the semiconductor body 2.

The main body 6 also comprises a passivation region 69, which is formed for example by silicon nitride (SiN) or nitride oxide and extends on the upper conductive structure 50, in direct contact; a portion of the passivation region 69 laterally coats the membrane 55.

The MEMS transducer 1 also comprises a cap 70 of semiconductor material, which is holed and is mechanically coupled to the coupling conductive region 68 so as to delimit a chamber, having the membrane 55 extending therewithin.

In practice, the membrane 55 is free of dielectric regions, therefore it does not include sub-regions with coefficients of thermal expansion different from each other, with a resulting advantage in terms of reduction of unwanted mechanical stresses within the membrane 55. Furthermore, the anchoring portion 37" allows to accurately control the geometry of the portion of the membrane 55 that is essentially suspended on the sensing cavity 39 and is therefore subject, in use, to deformation.

However, the manufacturing process of the membrane 55 envisages an etching operation of a stack of three layers intended to form the first, the second and the third internal region 36, 46, 56, respectively. The layer intended to form the second internal region 46 is formed by polysilicon permeable to gases, while the other two layers are formed by polysilicon impermeable to gases. However, the Applicant has observed how the presence of material discontinuities in the stack of three layers, and in particular the presence of the permeable polysilicon layer, may cause etch discontinuities and therefore may cause non-idealities in the manufacture. For example, the impurities present in the permeable polysilicon may cause residues on the landing surface of the etching.

In addition, the Applicant has observed how the presence of peripheral portions of the second internal region 46 that laterally face the upper trench 59, even if only temporarily during the manufacturing process, may entail unwanted variations in pressure within the sensing cavity 39.

### Summary

The aim of the present invention is therefore to provide a capacitive MEMS pressure transducer that overcomes at least in part the drawbacks of the prior art.

According to the present invention, a capacitive MEMS pressure transducer and a manufacturing process are provided, as defined in the attached claims.

### Brief Description of the Figures

For a better understanding of the present invention, embodiments thereof are now described, purely by way of nonlimiting example, with reference to the attached drawings, wherein:
- Figure 1 schematically shows a cross-section of a MEMS transducer;
- Figures 2 and 3 schematically show cross-sections of variants of the present MEMS transducer;
- Figures 4-9 schematically show cross-sections of the MEMS transducer shown in Figure 2, during successive steps of a manufacturing process;
- Figures 10-14 schematically show cross-sections of the MEMS transducer shown in Figure 3, during successive steps of a manufacturing process;
- Figure 15 schematically shows a cross-section of the MEMS transducer shown in Figure 2, during a step of a variant of the manufacturing process; and
- Figure 16 schematically shows a cross-section of the MEMS transducer shown in Figure 3, during a step of a variant of the manufacturing process.

### Description of Embodiments

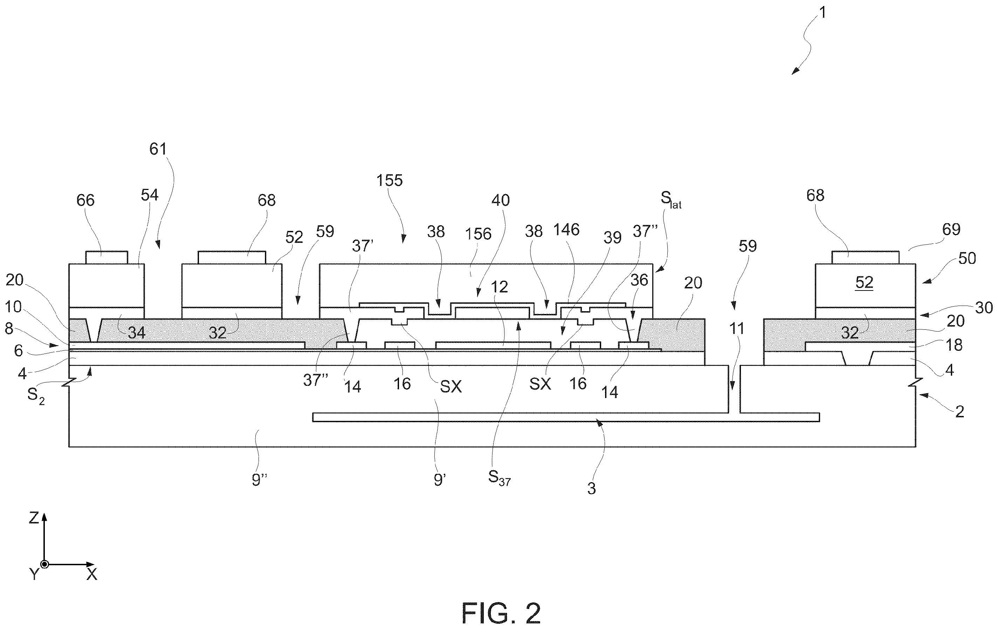

Figure 2 shows a first embodiment of a MEMS transducer 100, which is now described with reference to the differences with respect to the MEMS transducer 1 shown in Figure 1. Elements already present in the MEMS transducer 1 are indicated with the same reference signs, unless otherwise specified. For simplicity of representation, the cap 70, however optional, is not shown. Furthermore, although not further explained, variations with respect to the thicknesses mentioned with reference to Figure 1 are possible.

In detail, the annular region 42 and the peripheral portion 44 of the second upper conductive structure 40 are absent. Consequently, the annular region 52 and the peripheral portion 54 of the third upper conductive structure 50 directly contact, respectively, the annular region 32 and the peripheral portion 34 of the first upper conductive structure 30.

The membrane, here indicated by 155, is laterally delimited by a lateral surface Sₗₐₜ, which faces the upper trench 59. Purely by way of example, the membrane 155 may have an approximately cylindrical shape or may have a polygonal shape in top view, therefore it may have, for example, the shape of a parallelepiped or a polygonal-based prism; the shape of the lateral surface Sₗₐₜ varies accordingly.

The second internal region, here indicated by 146, is still formed by polysilicon permeable to gases, is layered and still extends on the first internal region 36 and within the holes 38, for example in a conformal manner, therefore without completely filling the holes 38, but coating the relative lateral walls and the respective bottoms. The portions of the second internal region 146 which extend on the bottom of the holes 38 face the sensing cavity 39.

In greater detail, the second internal region 146 does not laterally face the lateral surface Sₗₐₜ of the membrane 155. In other words, the second internal region 146 extends at a distance from the lateral surface Sₗₐₜ of the membrane 155.

In even greater detail, the second internal region 146 is overlaid, in direct contact, by a central portion of the third internal region, here indicated by 156. Furthermore, a perimeter portion of the third internal region 156 laterally surrounds the second internal region 146; this perimeter portion of the third internal region 156 overlies, in direct contact, a perimeter portion of the suspended portion 37' of the first internal region 36, which, without any loss of generality, protrudes laterally with respect to the underlying anchoring portion 37".

In practice, the perimeter portions of the suspended portion 37' of the first internal region 36 and of the third internal region 156 form the lateral wall of the membrane 155 and therefore define the lateral surface Sₗₐₜ, which, without any loss of generality, protrudes laterally with respect to the underlying anchoring portion 37". Furthermore, the first and the third internal region 36, 156 form a body of polysilicon impermeable to gases; the second internal region 146 is a monolithic region of polysilicon permeable to gases, which is encapsulated in such a body of polysilicon impermeable to gases, except for the portions of the second internal region 146 that extend on the bottom of the holes 38 and face the sensing cavity 39.

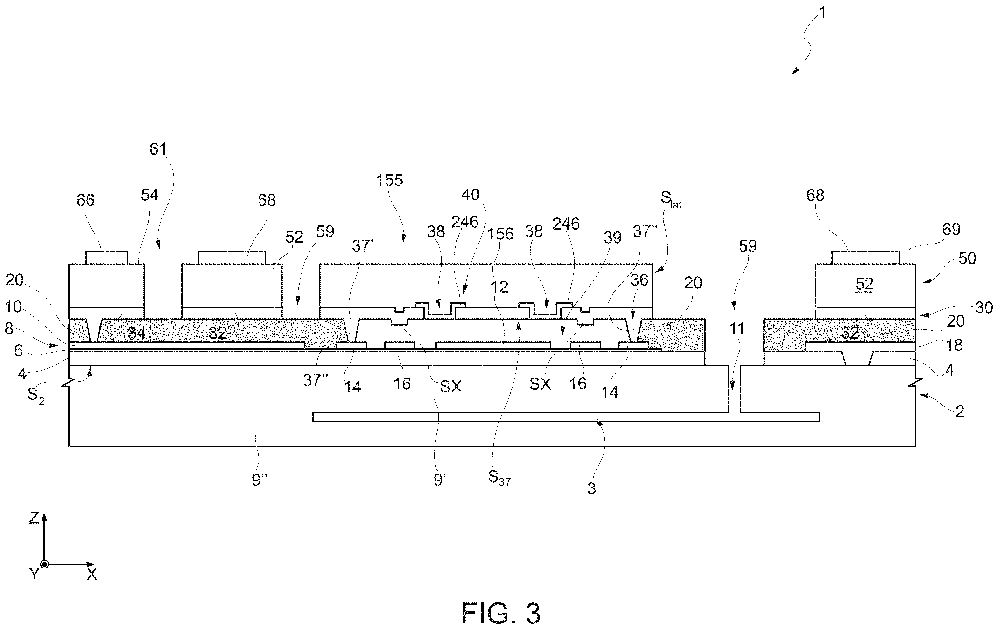

According to a variant shown in Figure 3, in lieu of the second internal region 146 a plurality of second internal regions 246 (two shown in Figure 3) is present, which are again formed by polysilicon permeable to gases and are spaced from each other. Each second internal region 246 is layershaped and coats the lateral wall and the bottom of a corresponding hole 38, for example in a conformal manner. Without any loss of generality, an upper portion of each second internal region 246 coats at the top a part of suspended portion 37' that surrounds the corresponding hole 38. The portions of the second internal regions 246 that extend on the bottom of the holes 38 therefore face the sensing cavity 39.

In practice, both in the variant shown in Figure 2 and in the variant shown in Figure 3, permeable polysilicon regions that face the lateral surface Sₗₐₜ are not present. Both the second internal region 146 and the second internal regions 246 form an intermediate structure of permeable polysilicon, which closes the holes 38 and is encapsulated within the impermeable body formed by the underlying first internal region 36 and the overlying third internal region 156, except for the portions that face the sensing cavity 39. This allows preventing gas exchanges between the sensing cavity 39 and the outside world, without the need to further seal the sensing cavity 39, for example by using a further layer of nitride; however, this last action would still require time to be carried out, during which the sealing of the sensing cavity 39 would not be optimal.

Again with reference to the prevention of gas exchanges between the sensing cavity 39 and the outside world, in order to reduce unwanted fluidic coupling between the sensing cavity 39 and the outside world, referring to the variant shown in Figure 2, the minimum distance between the lateral surface Sₗₐₜ and the second internal region 146 (intended as the minimum distance present between any point of the second internal region 146 and any point of the lateral surface Sₗₐₜ) may be at least equal to 1 µm. Furthermore, the variant shown in Figure 3 allows the permeable polysilicon to be further spaced from the lateral surface Sₗₐₜ; in this regard, the minimum distance between the lateral surface Sₗₐₜ and the second internal region 246 closest to the lateral surface Sₗₐₜ (intended as the minimum distance present between any point of the second internal region 246 closest to the lateral surface Sₗₐₜ and any point of the lateral surface Sₗₐₜ) may for example be at least equal to 10 µm.

Furthermore, as successively clarified, further advantages arise in the manufacturing processes of both variants, which are described hereinbelow.

In detail, the variant shown in Figure 2 may be manufactured starting from a semiconductive wafer 99 comprising the semiconductor body 2, in the following manner.

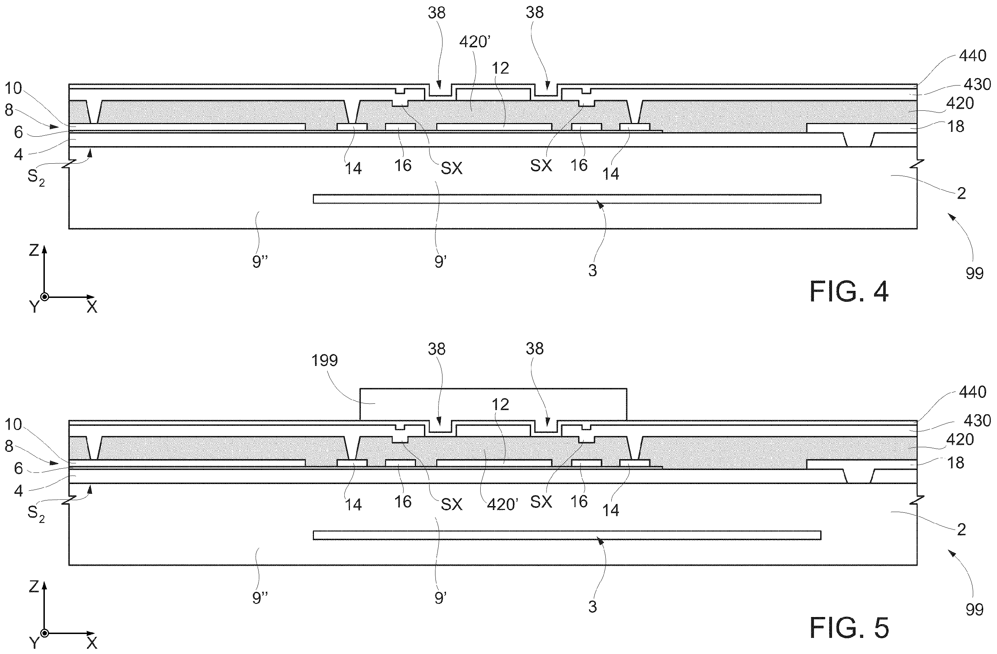

Initially, as shown in Figure 4, the buried cavity 3, the lower dielectric region 4, the stopping region 6, the ground contact region 18 and the lower conductive structure 8, which comprises the routing region 10, the lower electrode region 12, the lower anchoring region 14 and the covering region 16 are formed in a per se known manner.

Furthermore, a front dielectric layer 420 is formed, which is intended to form the upper dielectric region 20 and is formed for example by TEOS oxide.

Furthermore, a first conductive layer 430 of polysilicon impermeable to gases is formed on the front dielectric layer 420, which has a thickness comprised, for example, between 0.2µm and 1.5µm and includes portions which extend through the front dielectric layer 420 to contact the routing region 10 and the lower anchoring region 14. In this regard, hereinafter reference is made to the sacrificial region 420' to indicate the portion of the front dielectric layer 420 that is laterally delimited by the portion of the first conductive layer 430 which extends through the front dielectric layer 420 to contact the lower anchoring region 14 and is intended to form the anchoring portion 37" of the first internal region 36. A portion of the first conductive layer 430 extends above the sacrificial region 420', which is intended to form the suspended portion 37' of the first internal region 36. In addition, the sacrificial region 420' overlies the lower electrode region 12, the covering region 16 and the internal portion of the lower anchoring region 14.

As shown again in Figure 4, the first conductive layer 430 is traversed by the holes 38, which face the sacrificial region 420'. Furthermore, a second conductive layer 440 of polysilicon permeable to gases, with a thickness for example comprised between 100nm and 300nm, is present on the first conductive layer 430. Without any loss of generality, the second conductive layer 440 coats the lateral walls and the bottom of the holes 38 in a conformal manner, i.e. without filling them. The portions of sacrificial region 420' which form the bottoms of the holes 38 are then coated by corresponding portions of the second conductive layer 440, in direct contact.

Subsequently, as shown in Figure 5, a masking region 199 of oxide is formed (but variants are possible wherein the masking region 199 is formed by resist or a combination of oxide and resist), which overlies a portion of the second conductive layer 440, which in turn overlies, at a distance, the sacrificial region 420' and is intended to form the second internal region 146. The masking region 199 leaves exposed portions of the second conductive layer 440 that are laterally offset with respect to the underlying sacrificial region 420'; the exposed portions of the second conductive layer 440 overlie, inter alia, the portion of the first conductive layer 430 that extends through the front dielectric layer 420 to contact the lower anchoring region 14 and is intended to form the anchoring portion 37" of the first internal region 36.

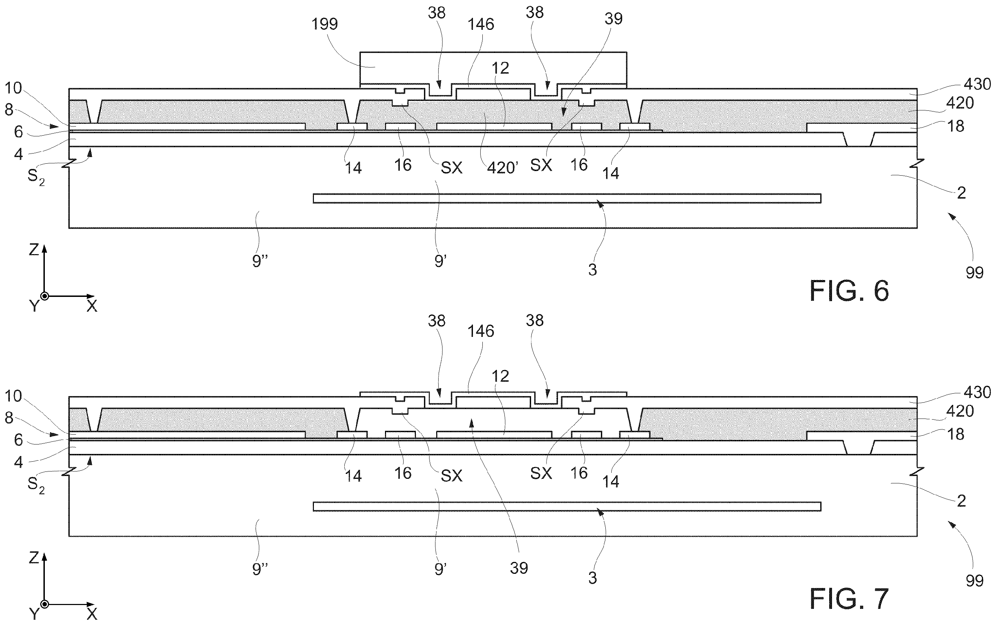

Subsequently, as shown in Figure 6, the exposed portions of the second conductive layer 440 are selectively removed, such that the residual portion of the second conductive layer 440 forms the second internal region 146. To this end, a "dry" etching is for example performed, wherein the masking region 199 functions as a "hard mask".

The selective removal of the exposed portions of the second conductive layer 440 entails the exposure of underlying portions of the first conductive layer 430.

Successively, as shown in Figure 7, the masking region 199 is removed by means of etching with gaseous hydrofluoric acid (HF), which is also flowed through the holes 38, thus through the portions of second internal region 146 that coat the bottoms of the holes 38. In this manner, the sacrificial region 420' is also removed; the sensing cavity 39 is thus formed. In case the masking region 199 is formed in whole or in part by resist, the etching with gaseous hydrofluoric acid is preceded by a "dry" etching to remove the resist from the masking region 199.

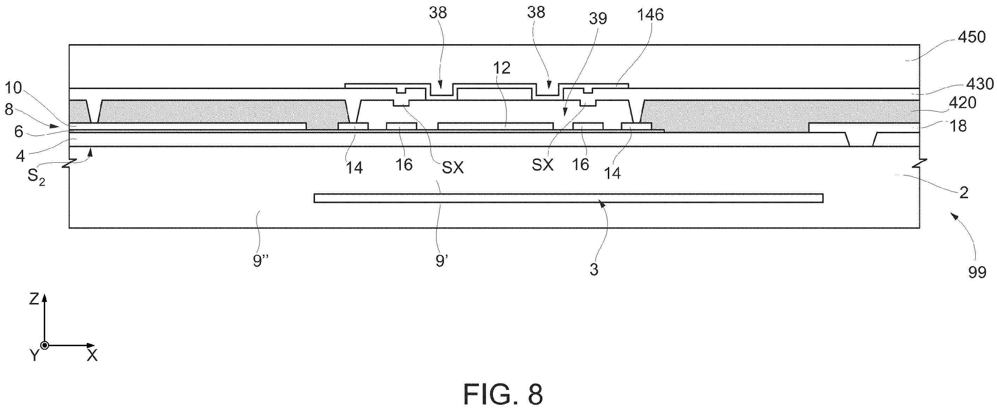

Subsequently, as shown in Figure 8, a third conductive layer 450 of polysilicon impermeable to gases is formed on the exposed portions of the first conductive layer 430 and on the second internal region 146. The third conductive layer 450 fills the holes 38, so as to close them hermetically, i.e. to prevent the gas from flowing through the holes 38. Furthermore, the third conductive layer 450 surrounds at the top and laterally the second internal region 146.

In particular, in order to avoid that polysilicon may penetrate the sensing cavity 39, creating unwanted contacts with the lower electrode region 12, the third conductive layer 450 may be formed by performing an epitaxial growth of polysilicon (e.g., at ambient pressure).

Subsequently, although not shown, a thermal treatment in a nitrogen environment may be performed, to create vacuum in the sensing cavity 39 or in any case to set the pressure value in the sensing cavity 39.

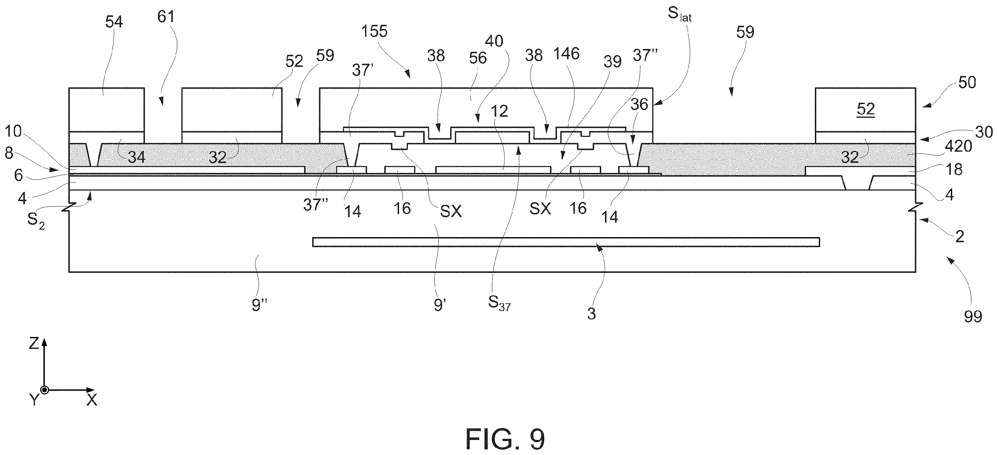

Successively, as shown in Figure 9, portions of the first and the third conductive layer 430, 450 are selectively removed, for example by performing a "dry" etching, such that the remaining portions of the first and the third conductive layer 430, 450 form the first and the third upper conductive structure 30, 50, respectively. In particular, the upper trench 59 and the opening 61 are formed, therefore the membrane 155 is also defined.

In greater detail, the selective removal of portions of the third conductive layer 450 and underlying portions of the first conductive layer 430 occurs with a same etching, without entailing the removal of permeable polysilicon, by virtue of the preceding patterning of the second conductive layer 440. The etching therefore involves regions formed by a same material, therefore without encountering material discontinuities, with resulting advantages in terms of reduction of manufacturing non-idealities.

Subsequently, although not shown, the manufacturing process may proceed in a manner known per se, so as to form, inter alia, the pads 66 and the trench 11, as well as to couple the cap 70.

The variant of the MEMS transducer 100 shown in Figure 3 may be manufactured following the manufacturing process described hereinafter with reference, for brevity, only to the differences with respect to the manufacturing process described with reference to Figures 4-9.

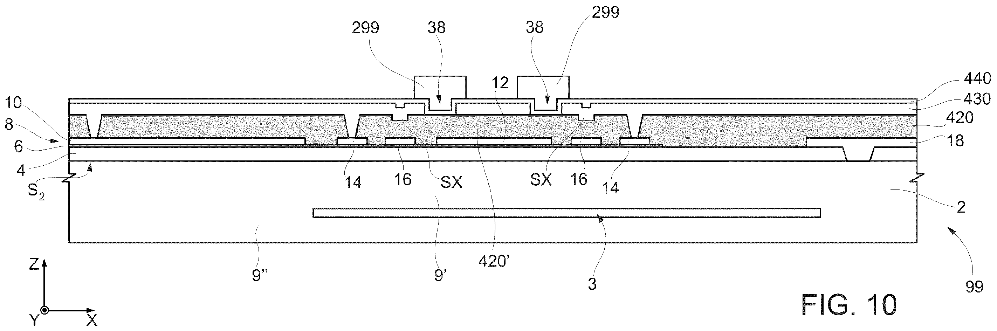

In lieu of the masking region 199, a plurality of masking regions 299 of oxide are formed (variants are also possible wherein the masking regions 299 are made of resist or a combination of resist and oxide), as shown in Figure 10. Each masking region 299 overlies a corresponding portion of the second conductive layer 440 that extends in a corresponding hole 38.

The masking regions 299 are separated from each other and leave exposed, as well as portions of the second conductive layer 440 that are laterally offset with respect to the underlying sacrificial region 420', also portions of the second conductive layer 440 that overlie, at a distance, the underlying sacrificial region 420'.

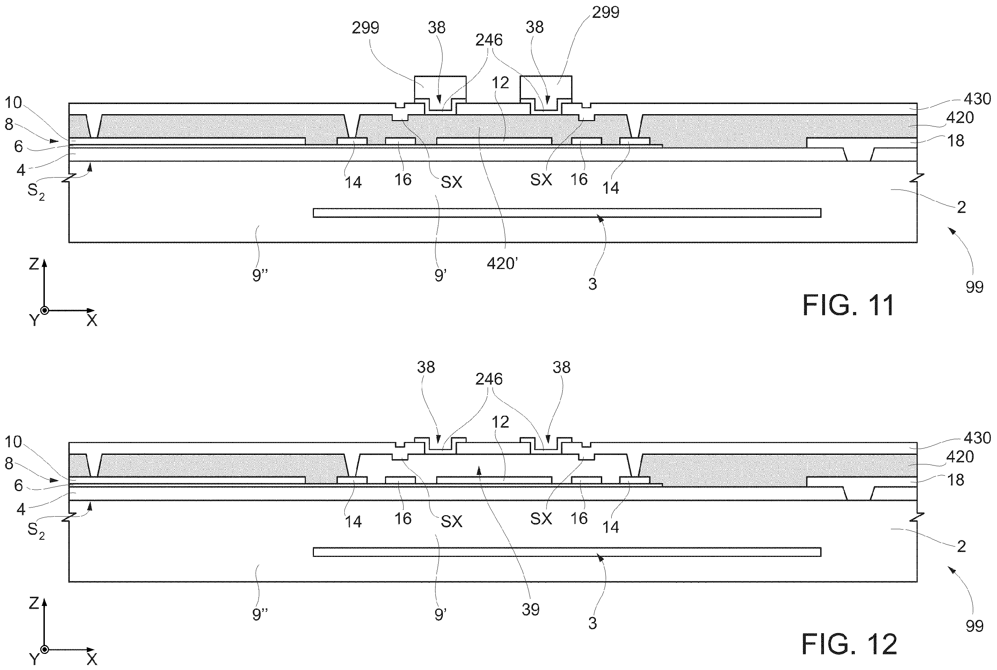

Subsequently, as shown in Figure 11, the exposed portions of the second conductive layer 440 are selectively removed, such that the residual portions of the second conductive layer 440 form the second internal regions 246. To this end, for example a "dry" etching is performed, wherein the masking regions 299 function as a mask.

The selective removal of the exposed portions of the second conductive layer 440 entails the exposure of underlying portions of the first conductive layer 430.

Successively, as shown in Figure 12, the masking regions 299 are removed by means of etching with gaseous hydrofluoric acid (HF), which is also flowed through the holes 38, thus through the portions of the second internal regions 246 that coat the bottoms of the holes 38. In this manner, the sacrificial region 420' is also removed; the sensing cavity 39 is thus formed. In case the masking regions 299 are instead formed in whole or in part by resist, the etching with gaseous hydrofluoric acid is preceded by a "dry" etching to remove the resist from the masking regions 299.

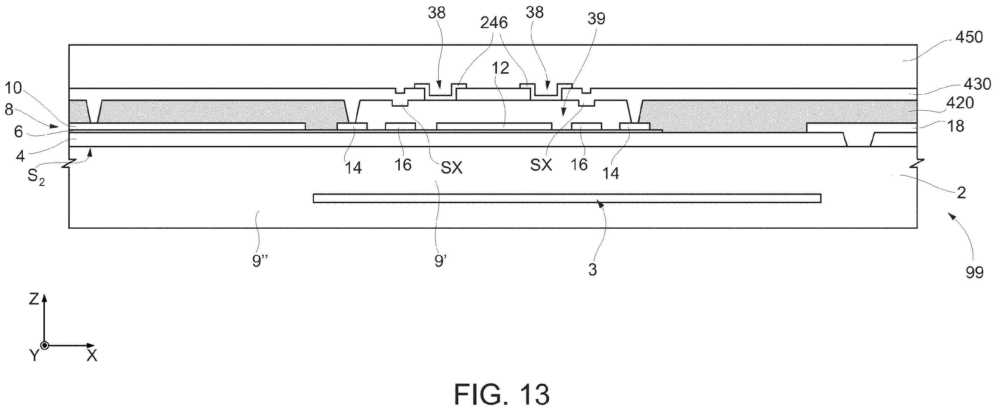

Subsequently, as shown in Figure 13, the third conductive layer 450 of polysilicon impermeable to gases is formed above the exposed portions of the first conductive layer 430 and above the second internal regions 246. The third conductive layer 450 fills the holes 38, so as to close them hermetically, i.e. so as to prevent the gas from flowing through the holes 38. Furthermore, the third conductive layer 450 surrounds at the top and laterally each second internal region 246.

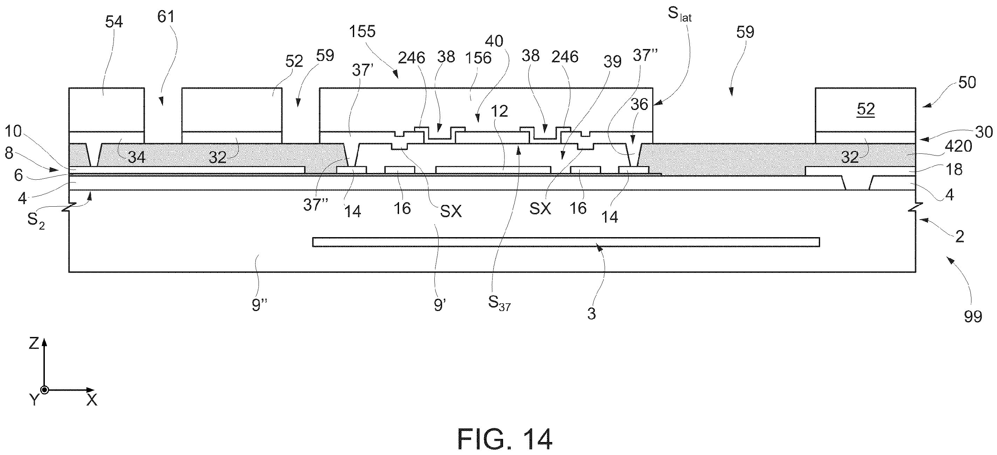

Successively, as shown in Figure 14, portions of the first and the third conductive layer 430, 450 are selectively removed, for example by performing a "dry" etching, such that the remaining portions of the first and the third conductive layer 430, 450 form the first and the third upper conductive structure 30, 50, respectively. In particular, the upper trench 59 and the opening 61 are formed, therefore the membrane 155 is also formed. Also in this case, the selective removal of portions of the third conductive layer 450 and of underlying portions of the first conductive layer 430 occurs with a same etching, without entailing the removal of permeable polysilicon, by virtue of the preceding patterning of the second conductive layer 440. The etching therefore involves regions formed by a same material, without encountering material discontinuities.

Subsequently, the manufacturing process may proceed in a manner known per se and therefore not shown.

Variants are also possible wherein, both as to the variant shown in Figure 2 and to the variant shown in Figure 3, the patterning of the second conductive layer 440 is carried out differently from what has been described.

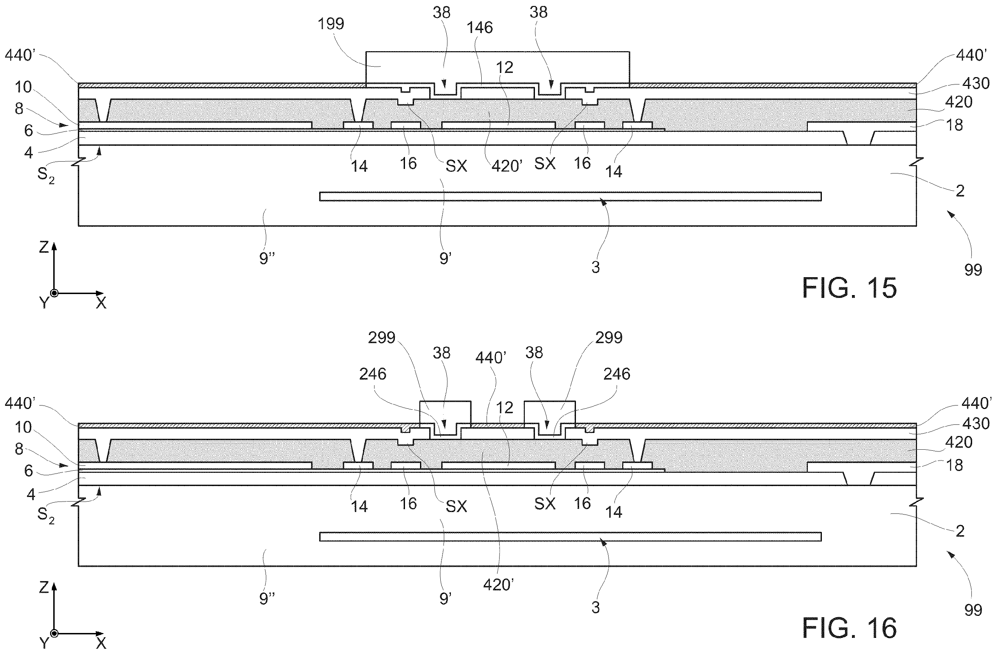

For example, with reference to the manufacturing process of the variant shown in Figure 2 of the MEMS transducer 100, following the formation of the masking region 199 of TEOS oxide, a thermal treatment may be performed that causes the oxidation of the exposed portions of the second conductive layer 440, as shown in Figure 15, wherein the oxidized portions of the second conductive layer 440 are indicated by 440', and wherein the portion of the second conductive layer 440 protected by the masking region 199 is already indicated by 146, as it coincides with the second internal region 146.

Subsequently, although not shown again, the operations described with reference to Figure 7 are performed. The masking region 199 of TEOS oxide, the sacrificial region 420' and the oxidized portions 440' of the second conductive layer 440 are then removed, by using gaseous hydrofluoric acid, so as to obtain again what has been shown in Figure 7. The manufacturing process may then proceed in the same manner as previously described.

With reference to the manufacturing process of the variant shown in Figure 3 of the MEMS transducer 100, successively to the formation of the masking regions 299, a thermal treatment may be performed instead so as to oxidize the portions of the second conductive layer 440 left exposed by the masking regions 299, as shown in Figure 16, wherein the oxidized portions of the second conductive layer 440 are still indicated by 440', and wherein the portions of the second conductive layer 440 protected by the masking regions 299 are already indicated by 246, as they coincide with the second internal regions 246.

Subsequently, although not shown again, the operations described with reference to Figure 12 are performed. The masking regions 299 of TEOS oxide, the sacrificial region 420' and the oxidized portions 440' of the second conductive layer 440 are then removed by using gaseous hydrofluoric acid, so as to obtain again what has been shown in Figure 12. The manufacturing process may then proceed in the same manner as previously described.

The advantages that the present solution affords are clear from the preceding description.

In particular, the patterning of the permeable polysilicon allows to avoid encountering material discontinuities during the etching of the first and the third conductive layers 430, 450. In this manner, the possibility of introducing impurities in the permeable polysilicon, which might cause non-idealities in the manufacturing process, is reduced and the sealing of the sensing cavity 39 is improved, since the second internal region 146 (or the second internal regions 246) do not face the lateral surface Sₗₐₜ of the membrane 155, but only the sensing cavity 39, therefore they cannot form unwanted fluidic channels between the sensing cavity 39 and the outside world.

Furthermore, the variant shown in Figure 2 is characterized by a single region of permeable polysilicon, with a resulting advantage in terms of reduction of the roughness of the membrane 155. The variant shown in Figure 3 instead allows the permeable polysilicon to be more spaced from the lateral surface Sₗₐₜ and the overall volume occupied by the permeable polysilicon, which represents the material at greatest risk of non-ideality within the membrane 155, to be reduced.

Finally, it is clear that modifications and variations may be made to the MEMS transducer and to the related manufacturing process previously described and illustrated, without departing from the scope of the present invention, as defined in the attached claims.

For example, variants are possible wherein the membrane 155 has a different shape, such as for example the shape of a polygonal-based prism, in which case the membrane 155 is laterally delimited by a plurality of lateral walls, which define the lateral surface Sₗₐₜ.

The buried cavity 3 may be absent.

The third conductive layer 450, and therefore also the third internal region 156 of the membrane 155, may be formed by amorphous silicon, rather than polysilicon.

The front dielectric layer 420, and therefore also the upper dielectric region 20, may be formed by dielectric material other than TEOS oxide.

Furthermore, the polysilicon permeable to gases may completely fill each hole 38, rather than conformally coating the bottom and the lateral wall, in which case the shapes of the second internal region 146 (or the second internal regions 246), the third internal region 156, the second conductive layer 440, and the third conductive layer 450 are modified accordingly.

## Claims

1. A MEMS pressure transducer (100) comprising:
- a semiconductor body (2);
- a fixed electrode region (12) arranged above the semiconductor body (2); and
- a membrane (155), which is suspended above the fixed electrode region (12) so as to delimit a cavity (39), the membrane (155) being deformable as a function of pressure and forming a variable capacitor together with the fixed electrode region (12);
and wherein the membrane (155) comprises:
- a lower conductive region (36) of polysilicon, which delimits the cavity (39) at the top and is traversed by one or more holes (38) which face the cavity (39), the lower conductive region (36) being impermeable to gases, except for the holes (38);
- an intermediate structure (146;246) of polysilicon permeable to gases, which closes said one or more holes (38); and
- an upper conductive region (156) of polysilicon or amorphous silicon, which extends on the intermediate structure (146;246) and on the lower conductive region (36), said upper conductive region (156) being impermeable to gases;
the MEMS pressure transducer (100) being **characterized in that** the membrane (155) is laterally delimited by a lateral surface (Sₗₐₜ), which is formed by the lower conductive region (36) and by the upper conductive region (156); and wherein the intermediate structure (146;246) does not face the lateral surface (Sₗₐₜ) of the membrane (155).

2. The MEMS pressure transducer (100) according to claim 1, wherein the minimum distance between the intermediate structure (146; 246) and the lateral surface (Sₗₐₜ) is at least equal to 1µm.

3. The MEMS pressure transducer (100) according to claim 1 or 2, wherein the intermediate structure (146) comprises a single intermediate region (146) of polysilicon permeable to gases, which extends on a part of the lower conductive region (36) and within the holes (38).

4. The MEMS pressure transducer (100) according to claim 1 or 2, wherein the intermediate structure (246) comprises a plurality of intermediate regions (246) of polysilicon permeable to gases separated from each other, each intermediate region (246) extending in a corresponding hole (38).

5. The MEMS pressure transducer (100) according to any of the preceding claims, further comprising a lower anchoring region (14) of conductive material, the lower anchoring region (14) and the fixed electrode region (12) being coplanar and laterally separated; and wherein the lower conductive region (36) forms a portion (37') of the membrane (155) and an upper anchoring region (37"), which laterally delimits the cavity (39) and extends to contact, at the bottom, the lower anchoring region (14).

6. A process for manufacturing a MEMS pressure transducer (100), comprising:
- forming a semiconductor body (2);
- forming a fixed electrode region (12) arranged above the semiconductor body (2); and
- forming a membrane (155), which is suspended above the fixed electrode region (12) so as to delimit a cavity (39), the membrane (155) being deformable as a function of pressure and forming a variable capacitor together with the fixed electrode region (12);
and wherein forming the membrane (155) comprises:
- forming a lower conductive region (36) of polysilicon, which delimits the cavity (39) at the top and is traversed by one or more holes (38) which face the cavity (39), the lower conductive region (36) being impermeable to gases, except for the holes (38);
- forming an intermediate structure (146;246) of polysilicon permeable to gases, which closes said one or more holes (38); and
- forming an upper conductive region (156) of polysilicon or amorphous silicon, which extends on the intermediate structure (146;246) and the lower conductive region (36), said upper conductive region (156) being impermeable to gases;
the manufacturing process being **characterized in that** the membrane (155) is laterally delimited by a lateral surface (Sₗₐₜ), which is formed by the lower conductive region (36) and the upper conductive region (156); and wherein the intermediate structure (146;246) does not face the lateral surface (Sₗₐₜ) of the membrane (155).

7. The manufacturing process according to claim 6, further comprising:
- forming a front dielectric layer (420) above the fixed electrode region (12);
- forming a first conductive layer (430), which is formed by polysilicon impermeable to gases and extends on the front dielectric layer (420) and through the front dielectric layer (420), so as to laterally delimit a sacrificial portion (420') of the front dielectric layer (420), said first conductive layer (430) being further traversed by said one or more holes (38), which traverse a portion of the first conductive layer (430) that overlies the sacrificial portion (420');
- forming a second conductive layer (440) on the first conductive layer (430), said second conductive layer (440) being formed by polysilicon permeable to gases and extending within the holes (38); and
- selectively removing portions of the second conductive layer (440), so that the residual portions of the second conductive layer (440) form the intermediate structure (146;246), which comprises portions which face the sacrificial portion (420');
- removing the sacrificial portion (420') by flowing a gaseous chemical agent through the portions of the intermediate structure (146;246) that face the sacrificial portion (420');
- on the intermediate structure (146;246) and the first conductive layer (430), forming a third conductive layer (450), which is formed by polysilicon or amorphous silicon and is impermeable to gases; and
- with a same etching, selectively removing portions of the first and third conductive layers (430, 450), such that the residual portions of the first and third conductive layers (430, 450) form the lower conductive region (36) and the upper conductive region (156) of the membrane (155), respectively.

8. The manufacturing process according to claim 7, wherein selectively removing portions of the second conductive layer (440) comprises performing a masked etching, before removing the sacrificial portion (420').

9. The manufacturing process according to claim 7, wherein selectively removing portions of the second conductive layer (440) comprises performing a thermal treatment to oxidize portions (440') of the second conductive layer (440) and successively removing the oxidized portions (440') of the second conductive layer (440) during the removal of the sacrificial portion (420').

10. The manufacturing process according to any of claims 6 to 9, wherein the intermediate structure (146) comprises a single intermediate region (146) of polysilicon permeable to gases, which extends on a part of the lower conductive region (36) and within the holes (38).

11. The manufacturing process according to any of claims 6 to 9, wherein the intermediate structure (246) comprises a plurality of intermediate regions (246) of polysilicon permeable to gases separated from each other, each intermediate region (246) extending in a corresponding hole (38).
